# EUROPEAN PATENT APPLICATION

(11) **EP 2 180 502 A1**
(43) Date of publication of application: **28.04.2010**
(21) Application number: 09173978.9
(22) Date of filing: 23.10.2009
(51) Int. Cl.: H01J 37/34, C23C 14/34

(54) **Rotatable sputter target backing cylinder, rotatable sputter target, method of producing a rotatable sputter target, and coating installation**

(30) Priority: 24.10.2008 US 258227; 24.10.2008 EP 08167571
(71) Applicant: Applied Materials, Inc., Santa Clara, CA 95054 (US)
(72) Inventor: Schaefer, Michael, 63674, Altenstadt (DE); Trassl, Roland, 35392, Giessen (DE); Liu, Jian, 63538, Grosskrotzenburg (DE)
(74) Representative: Zimmermann & Partner

(57) **Abstract**

A rotatable target device for sputtering installations, the rotatable target device including: a rotatable target base (4) adapted for holding a solid target cylinder (5), the solid target cylinder having an inner axial face (54), an outer axial face (55) and at least one front face (56) connecting the inner axial face with the outer axial face; wherein the rotatable target base comprises a flexible element (23; 230), a first face (3) adapted to the shape of the inner axial face of the solid target cylinder and a second face (250; 81) adapted to hold the flexible element outside of the solid target cylinder.

## Description

### TECHNICAL FIELD

Embodiments generally relate to sputtering installations. More particularly, they relate to a rotatable target device, a rotatable target base device, a rotatable target, a coating installation, and a method for producing a rotatable target.

### BACKGROUND ART

Thin-film deposition of material on substrates may be accomplished in many ways, for example by evaporation or sputtering of the coating material in a vacuum chamber. Typical examples of thin-film deposition by sputtering are sputter deposition applications in solar wafer manufacturing or in semiconductor device production.

When operating a sputtering cathode, a plasma is established and ions of the plasma are accelerated onto a target of coating material to be deposited onto the substrates. This bombardment of the target results in ejection of atoms of the coating material, which accumulate as a deposited film on the substrate below the sputtering cathode. In order to obtain increased deposition rates, the use of magnetically enhanced cathodes has been proposed, which may also be referred to as magnetron sputtering.

Typical magnetically enhanced sputtering cathodes may include a flat target plate and an array of magnets mounted in a fixed position relative to the target plate. The magnetic field provided by the magnets establishes the path(s) or the region along which sputtering of the target plate materials takes place.

Other typical magnetically enhanced sputtering cathodes include a cylindrical rotatable tube, e.g. a backing tube, having a layer of the target material applied to the outer surface thereof. Magnetic means, which may include an array of magnets, are arranged inside the tube and provide a magnetic field. The tube is rotatable about its longitudinal axis so that it can be turned relative to the magnetic means to selectively bring different portions or segments of the target material on the outer surface thereof into position opposite to the magnets and within the magnetic field.

In the manufacture of rotatable magnetron sputtering cathodes, the target material may for example be applied by spraying onto the outer surface of a backing tube. Furthermore, the target material of typical sputtering targets may be depleted or consumed quickly, e.g. within a week.

### SUMMARY

In light of the above, a rotatable target device according to claim 1, a rotatable target base device according to claim 3, a rotatable target according to claim 10, a coating installation according to claim 13, and a method for producing a rotatable target according to claim 14 are provided.

In one embodiment, a rotatable target device for sputtering installations includes: a rotatable target base adapted for holding a solid target cylinder, the solid target cylinder having an inner axial face, an outer axial face and at least one front face connecting the inner axial face with the outer axial face; wherein the rotatable target base includes a flexible element, a first face adapted to the shape of the inner axial face of the solid target cylinder and a second face adapted to hold the flexible element outside of the solid target cylinder.

In another embodiment, a rotatable target base device for sputtering installations is provided, wherein the target base device is adapted for receiving at least one solid target cylinder, the rotatable target base device including a target base cylinder having an axis, a lateral surface, a middle part, a first end region, and a second end region opposite to the first end region; and at least one target fixation means adapted to provide a target adjusting gap which is variable substantially in parallel to at least one element chosen from the lateral surface and the axis of the target base cylinder.

In one embodiment, a rotatable target for sputtering installations includes a rotatable target device for sputtering installations, the rotatable target device including: a rotatable target base adapted for holding a solid target cylinder, the solid target cylinder having an inner axial face, an outer axial face and at least one front face connecting the inner axial face with the outer axial face; wherein the rotatable target base includes a flexible element, a first face adapted to the shape of the inner axial face of the solid target cylinder and a second face adapted to hold the flexible element outside of the solid target cylinder.

In one embodiment, a rotatable target for sputtering installations is provided, including a rotatable target base device for sputtering installations, wherein the target base device is adapted for receiving at least one solid target cylinder; the rotatable target base device including a target base cylinder having an axis, a lateral surface, a middle part, a first end region, and a second end region opposite to the first end region; and at least one target fixation means adapted to provide a target adjusting gap which is variable substantially in parallel to at least one element chosen from the lateral surface and the axis of the target base cylinder; the rotatable target base device having at least one solid target cylinder arranged on the lateral surface of the target base cylinder, wherein the at least one target fixation means provides a target adjusting gap which is variable substantially in parallel to at least one element chosen from the lateral surface and the axis of the target base cylinder.

In one embodiment, a coating installation includes a rotatable target device for sputtering installations, the rotatable target device including: a rotatable target base adapted for holding a solid target cylinder, the solid target cylinder having an inner axial face, an outer axial face and at least one front face connecting the inner axial face with the outer axial face; wherein the rotatable target base includes a flexible element, a first face adapted to the shape of the inner axial face of the solid target cylinder and a second face adapted to hold the flexible element outside of the solid target cylinder.

In one embodiment, a coating installation including a rotatable target base device for sputtering installations is provided, wherein the target base device is adapted for receiving at least one solid target cylinder, the rotatable target base device including a target base cylinder having an axis, a lateral surface, a middle part, a first end region, and a second end region opposite to the first end region; and at least one target fixation means adapted to provide a target adjusting gap which is variable substantially in parallel to at least one element chosen from the lateral surface and the axis of the target base cylinder.

In one embodiment, a method of producing a rotatable target for sputtering installations includes: providing a rotatable target device for sputtering installations, the rotatable target device including: a rotatable target base adapted for holding a solid target cylinder, the solid target cylinder having an inner axial face, an outer axial face and at least one front face connecting the inner axial face with the outer axial face; wherein the rotatable target base includes a flexible element, a first face adapted to the shape of the inner axial face of the solid target cylinder and a second face adapted to hold the flexible element outside of the solid target cylinder; providing a solid target cylinder; the method including at least one step chosen from: arranging the solid target cylinder on the lateral surface of the target base cylinder adjacent to the at least one target fixation means; arranging at the first end region of the target base cylinder one of the at least one target fixation means, and arranging at the second end region of the target base cylinder one of the at least one target fixation means.

In one embodiment, a method of producing a rotatable target for sputtering installations includes: providing a rotatable target base device for sputtering installations, wherein the target base device is adapted for receiving at least one solid target cylinder; the rotatable target base device including a target base cylinder having an axis, a lateral surface, a middle part, a first end region, and a second end region opposite to the first end region; and at least one target fixation means adapted to provide a target adjusting gap which is variable substantially in parallel to at least one element chosen from the lateral surface and the axis of the target base cylinder; providing a solid target cylinder; the method including at least one step chosen from: arranging the solid target cylinder on the lateral surface of the target base cylinder adjacent to the at least one target fixation means; arranging at the first end region of the target base cylinder one of the at least one target fixation means, and arranging at the second end region of the target base cylinder one of the at least one target fixation means.

Further features and details are evident from the dependent claims, the description and the drawings.

Embodiments are also directed to apparatuses for carrying out the disclosed methods and including apparatus parts for performing described method steps. Furthermore, embodiments are also directed to methods by which the described apparatus operates or by which the described apparatus is manufactured. It may include method steps for carrying out functions of the apparatus or manufacturing parts of the apparatus. The method steps may be performed by way of hardware components, firmware, software, a computer programmed by appropriate software, by any combination thereof or in any other manner.

### BRIEF DESCRIPTION OF THE DRAWINGS

So that the manner in which the above recited features of embodiments can be understood in detail, a more particular description of embodiments, briefly summarized above, may be had by reference to examples of embodiments. The accompanying drawings relate to embodiments and are described in the following. Some of the above mentioned embodiments will be described in more detail in the following description of typical embodiments with reference to the following drawings in which:

Fig. 1 shows schematically a cross sectional view of a rotatable target including a rotatable target base device for sputtering installations according to one example of embodiments disclosed herein;

Figs. 2a and 2b show schematically a target base cylinder and a target fixation means, respectively, of the rotatable target base device of the example shown in Fig. 1;

Fig. 3a shows schematically a cross sectional view of a rotatable target including a rotatable target base device for sputtering installations according to one example of embodiments disclosed herein;

Fig. 3b shows schematically a target adjusting means of the rotatable target base device of the examples shown in Figs. 1, 2a and 3a;

Figs. 4 shows schematically a cross sectional view of a retaining means of the example shown in Fig. 1;

Fig. 5 shows schematically a cross sectional view of a rotatable target including a rotatable target base device for sputtering installations according to a further example of embodiments disclosed herein;

Fig. 6 shows schematically a cross sectional view of a rotatable target including a rotatable target base device for sputtering installations according to a further example of embodiments disclosed herein;

Fig. 7 shows schematically a cross sectional view of a rotatable target including a rotatable target base device for sputtering installations according to a further example of embodiments disclosed herein.

### DETAILED DESCRIPTION OF THE DRAWINGS

Reference will now be made in detail to the various embodiments, one ore more examples of which are illustrated in the figures. Each example is provided by way of explanation, and is not meant as a limitation of the invention. It is contemplated that elements of one embodiment may be advantageously utilized in other embodiments without further recitation.

Without limiting the scope, in the following the examples and embodiments of the rotatable target device, of the rotatable target base device, of the rotatable target, of the method of producing a rotatable target, and of the coating installation are described referring to sputtering applications. Typically, the rotatable target device and/or the rotatable target base device include vacuum-compatible materials and the coating installation is a vacuum coating installation. Typical applications of embodiments described herein are for example sputter deposition applications in the production of displays, such as LCD, TFT displays and OLED (Organic Light Emitting Diode), in solar wafer manufacturing and in semiconductor device production.

Within the following description of the drawings, the same reference numbers refer to the same components. Generally, only the differences with respect to the individual embodiments are described.

Without limiting the scope, in the following the target base cylinder of the rotatable target base device will e.g. be referred to as rotatable target base, backing cylinder or backing tube. The rotatable target will e.g. include the rotatable target base and the solid target cylinder.

According to a first embodiment, a rotatable target device for sputtering installations includes: a rotatable target base adapted for holding a solid target cylinder, the solid target cylinder having an inner axial face, an outer axial face and at least one front face connecting the inner axial face with the outer axial face; wherein the rotatable target base includes a flexible element, a first face adapted to the shape of the inner axial face of the solid target cylinder and a second face adapted to hold the flexible element outside of the solid target cylinder. In embodiments, the flexible element may be held on the first face and/or adjacent to the solid target cylinder. In some embodiments, the flexible element may be held in a row with the solid target cylinder, in an aligned row with the solid target cylinder, and/or axially aligned with the solid target cylinder.

In some embodiments, which can be combined with any embodiment described herein, the flexible element is adapted to be in direct contact with the front face of the solid target cylinder, and/or includes a solid element adapted to be in direct contact with the front face of the solid target cylinder.

According to a second embodiment, a rotatable target base device for sputtering installations is provided, wherein the target base device is adapted for receiving a solid target cylinder, the rotatable target base device including a target base cylinder having an axis, a lateral surface, a middle part, a first end region and a second end region opposite to the first end region, and at least one target fixation means adapted to provide a target adjusting gap which is variable substantially in parallel to at least one element chosen from the lateral surface and the axis of the target base cylinder. At least one of the first and the second end regions may have a maximum outer diameter substantially equal to or less than an outer diameter of the middle part. The target fixation means may include at least one element chosen from a retaining means and a target adjusting means, the target adjusting means being adapted to provide the target adjusting gap and/or being adapted to be provided in the target adjusting gap. The target base cylinder may be tubular and the target fixation means may be adapted to provide the target adjusting gap variable substantially in parallel to the axis.

In above mentioned first embodiment, the rotatable target base may be the target base cylinder of any embodiment described herein, and/or the first face may be the lateral surface of any embodiment described herein. Further, in the first embodiment, the second face may be included in at least one element chosen from: the target base cylinder according to embodiments described herein, the retaining means of above second and any other embodiment described herein, and one of the elements of the retaining means according to embodiments described herein. The flexible element may be or may be included in at least one of the at least one target fixation means according to any embodiment described herein or may be or may be included in the target adjusting means according to any embodiment described herein. Further, the solid element may be at least one element chosen from: a part of the retaining means, a compression flange, and a flange bearing, according to any embodiment described herein.

The target base device is for example intended for concentrically arranging a solid target cylinder on the target base cylinder. Further, the solid target cylinder may be a hollow cylinder. By arranging the solid target cylinder on the target base cylinder, typically a rotatable target results. The rotatable target base device may be for a substantially horizontal mounting of a rotatable target in a sputtering installation. The rotatable target base device may also be for a substantially vertical mounting of a rotatable target. Typically, the lateral surface of the target base cylinder may be understood as the cylinder barrel or the mantle of the cylinder.

Because of the flexible element and/or the target adjusting gap, embodiments disclosed herein allow for a thermal expansion of the solid target cylinder in axial direction, when the target cylinder is disposed on the rotatable target device or rotatable target base device, respectively. Hence, in case of a thermal expansion of the solid target cylinder, no damage or cracking of the solid target cylinder occurs, even if the material of the solid target cylinder includes Silicon or is formed of Silicon of a high purity.

Embodiments disclosed herein allow for providing a target, which may be a solid target cylinder, on a backing cylinder, since access from at least one end of the backing cylinder is possible. This is e.g. due to the structure of the backing cylinder of some embodiments, in which at least one end region of the backing cylinder has a maximum outer diameter substantially equal to or less than the outer diameter of the middle part of the backing cylinder. Therefore, a cylindrical or tubular solid target having an inner diameter matching or being larger than the outer diameter of the middle part of the backing cylinder may be easily placed on the backing cylinder. The target may be designed for use as a bonded or non-bonded target, typically as a non-bonded target. Furthermore, in contrast to backing cylinders for sprayed targets, using embodiments described herein makes it possible to array a plurality of cylindrical or tubular solid targets or targets sleeves for bonded or non-bonded targets on a backing cylinder. Moreover, the rotatable target base device according to embodiments disclosed herein may be used repeatedly and the rotatable target may be restored by exchanging the cylindrical targets.

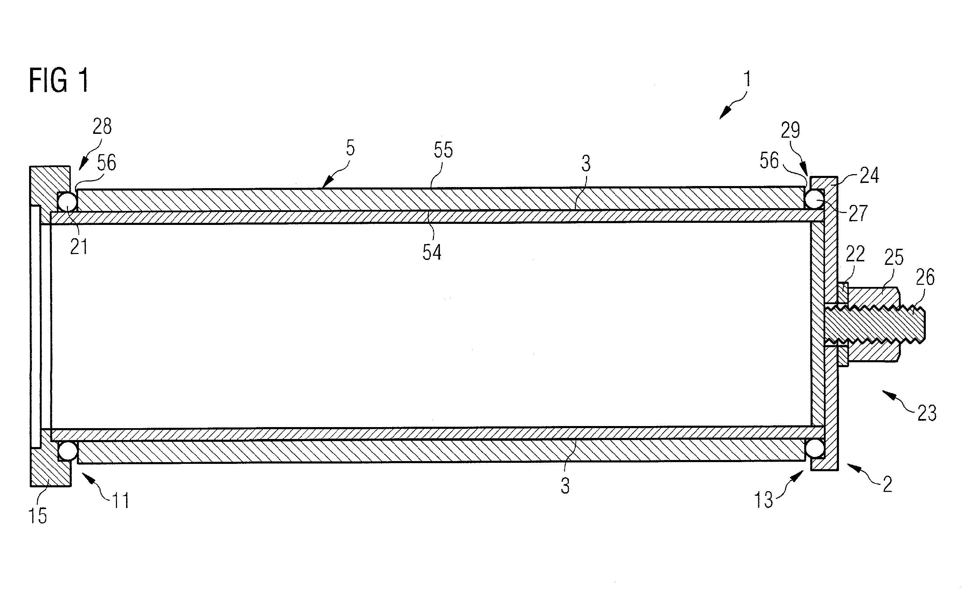

Fig. 1 shows schematically a rotatable target 1 for sputtering installations according to one example of embodiments disclosed herein. The rotatable target 1 typically includes a rotatable target base device 2 and a tubular solid target 5, also referred to herein as cylindrical target or target 5.

In embodiments described herein, the target 5 has an inner axial face 54, an outer axial face 55, and at least one front face 56 connecting the inner axial face 54 with the an outer axial face 55. Further, in embodiments described herein, the rotatable target base device includes a flexible element 23 or 230, a first face 3 adapted to the shape of the inner axial face of the solid target cylinder and a second face 250 or 81 adapted to hold the flexible element outside of the solid target cylinder.

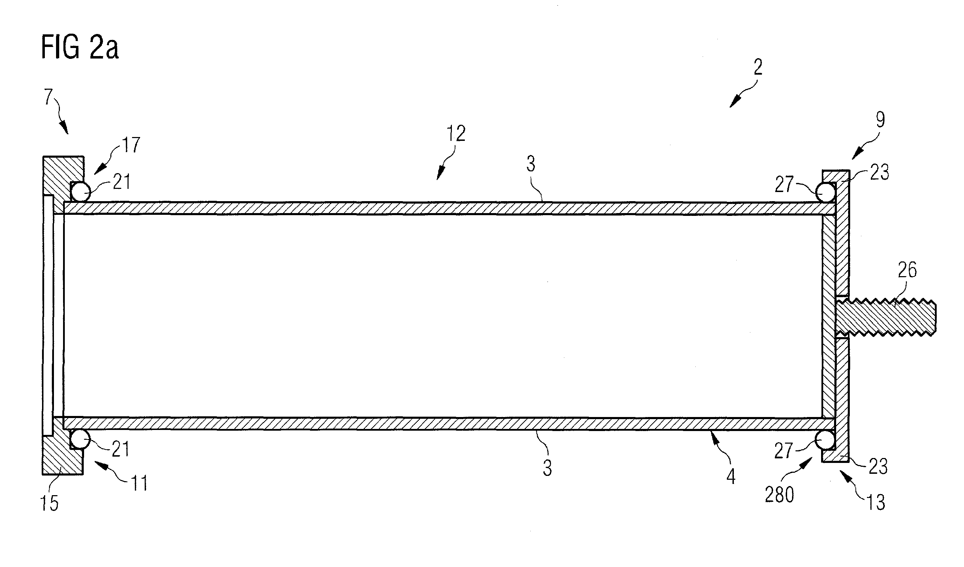

The rotatable target base device 2 of the example illustrated in Fig. 1 is further schematically shown in Fig. 2a and includes a backing tube 4. In some examples of embodiments disclosed herein, at least one end region of the backing tube has a maximum outer diameter substantially equal to or less than an outer diameter of a middle part of the backing tube. In the example shown in Fig. 1, the rotatable target base device 2 additionally includes two target fixation means 11, 13.

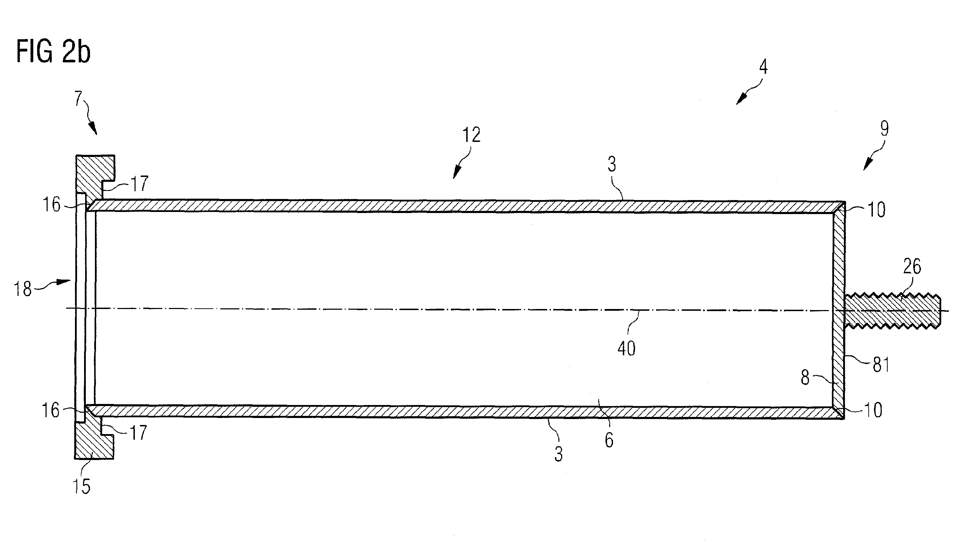

Backing tube 4 of the present example is schematically illustrated in Fig. 2b and has an axis 40 (broken line), a middle part 12, a lateral surface 3, a first end region 7 and a second end region 9. In the present example, the second end region 9 has a maximum outer diameter substantially equal to or less than the outer diameter of the middle part 12. In some examples of embodiments, the backing tube 4 is closed at the second end region 9 by a lid 8 at a welded joint 10. In addition, at the first end region 7, a connecting means for connecting the target base device to a target base support may be provided. In the present example, the connecting means is an annular flange 15, which may be welded at welding joint 16 to the first end region 7 of the backing tube 4. In other examples, flange 15 may be a clamping collar or a screwed collar and may be removable. By flange 15, backing tube 4 is provided with an opening 18. Furthermore, backing tube 4 may include an interior space 6 for containing at least one element selected from the group consisting of a magnet device and a cooling system.

In embodiments disclosed herein, the rotatable target base device may include one ore more target fixation means, one of the target fixation means being adapted for being provided at the at least one of the first and the second end regions and being removable. In one example of embodiments disclosed herein, at least one target fixation means may be provided at at least one of the first and the second end regions. In a variation of this example, at least one of the target fixation means may be removable.

According to one example of embodiments disclosed herein, the first end region 7 and the second end region 9 of the backing tube 4 are each provided with one of the target fixation means 11, 13. The target fixation means 11, 13 may each include a retaining means and a target adjusting means. In the example illustrated in Figs. 1, 2a and 2b, the target fixation means 11 is provided at the first end region 7 and the target fixation means 13 is provided at the second end region 9 of backing tube 4. At least the target fixation means 13 may be removable from the backing tube 4.

As shown in Fig. 2b, flange 15 of the backing tube 4 may include an annular recess 17 adjacent to the lateral surface 3 of the backing tube 4. Flange 15 and annular recess 17 are parts of the target fixation means 11. Flange 15 serves as the retaining means of the target fixation means 11. Annular recess 17 acts as an adjusting recess of the target fixation means 11.

Fig. 2a illustrates the backing tube 4 and the target fixation means 11 and 13 of the rotatable target base device 2 of the present example in an assembled state. The tubular solid target 5 of rotatable target 1 is not shown. For completion of the target fixation means 11, in annular recess 17 of flange 15 a coiled annular spring 21 may be provided. Furthermore, the assembled target fixation means 13 includes an annular locking means 23. In the present example, as shown in Fig. 1, locking means 23 includes a screw nut 25 and a compression flange 24, and at lid 8 of the backing tube 4 a central bolt 26 is provided as a flange bearing. The central bolt 26 has an external thread corresponding to an internal thread of nut 25. Nut 25 may further include a washer 22 as a flange fixation member. Locking means 23 provides an annular recess 280 adjacent to the lateral surface 3. The recess 280 may be established by corresponding diameters of compression flange 24. In the assembled state, compression flange 24 is concentrically positioned with a central bore 240 on central bolt 26, while contacting lid 8 of the backing tube 4, and the recess 280 is filled with a coiled annular spring 27.

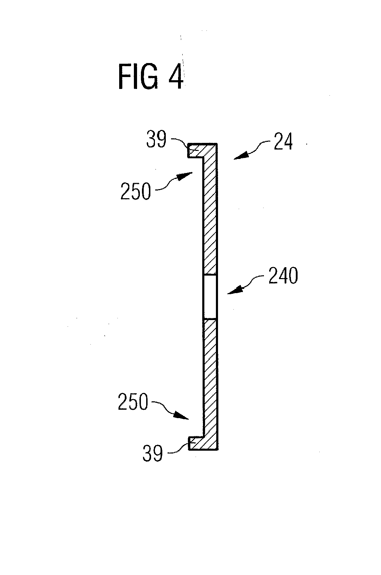

As shown in Fig. 4, which schematically illustrates compression flange 24 of locking means 23, the compression flange 24 includes the central bore 240 and at the outermost circumference a lateral annular protrusion 39. Thereby, the annular recess 280, which is shown in Fig. 2a as containing the spring 27, is provided, when mounting the locking means 23 at backing tube 4. The shape, width and the inner diameter of compression flange 24 are suitably chosen, in order to provide a good match of the locking means 23 and the spring 27, when assembled.

In summary, in the present example, locking means 23, which includes in the present example bolt 26, the screw nut 25 and the compression flange 24, forms the retaining means of target fixation means 13, whereas spring 27 is provided as target adjusting means of target fixation means 13. Further, in the present example, flange 15 is the retaining means of target fixation means 11 and spring 21 is the target adjusting means of target fixation means 11.

Fig. 1 shows the rotatable target 1 in an assembled state. The distance between flange 15 and locking means 23, in the present example the distance between flange 15 and compression flange 24, is larger than the length of the tubular solid target 5. Target 5 is positioned at the lateral surface 3 of the backing tube 4 and disposed between springs 21 and 27 of the target fixation means 11 and 13, respectively. Hence, target adjusting gaps 28 and 29 are provided between flange 15 and locking means 23, respectively, and the tubular solid target 5. Thereby, thermal expansion of the target 5 in parallel to the rotational axis, i.e. in the present example the longitudinal axis, of the backing tube 4 is possible and undesired effects of such a thermal expansion are avoided. Because of the spring tensions of springs 21 and 27, target 5 is aligned or even centered on the backing tube 4. Thereby, an optimal position of the tubular solid target 5 in parallel to the rotational axis of the rotatable target 1 may be achieved. The springs 21 and 27 hold the target 5 in a fixed position, even though gaps 28 and 29 are provided.

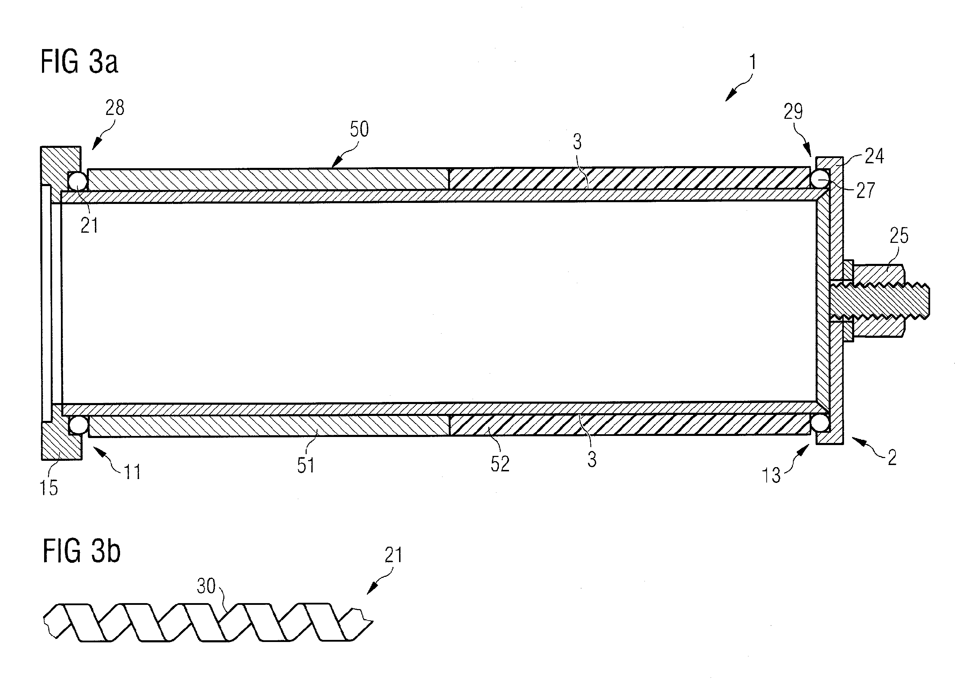

At least one of springs 21 and 27 may include at least one material selected from the group of electrically conductive material, metal, and stainless steel. Typically, springs 21 and 27 may be made from a flat metal stripe, which is coiled in itself. Hence, springs 21 and 27 may provide an electrical contact. This may typically be desirable for providing a defined electrical potential at least between flange 15 and the tubular solid target 5 shown in Fig. 1 via spring 21. Fig. 3a illustrates another example of rotatable target 1 of embodiments disclosed herein, having a tubular solid target 50 including two adjacent tubular pieces 51 and 52. In such a case, each piece 51 and 52 may be provided with a defined electrical potential by the respective adjacent spring 21, 27.

As an example of annular coiled springs 21 and 27, in Fig. 3b spring 21 is illustrated. In the present example, spring 21 is made from a flat metal stripe 30, which is coiled in itself. The resulting coil of the flat metal stripe 30 is formed as a ring (not shown) having a size and a diameter suitable for filling the recess 17 of flange 15. Accordingly, the diameter of spring 27 is sized to suitably fill the recess 280 formed by compression flange 24 mounted at backing tube 4. As depicted in Fig. 3b, at the outer circumference of spring 21, flat faces of spring 21 are positioned. Therefore, when spring 21 is made from electrically conductive material, the intensity of the electrical contact between the spring and the adjacent flange 15 and the target 5 is increased.

In examples of embodiments disclosed herein, the inner diameter of the solid target cylinder may be substantially equal to or larger than the outer diameter of the middle part of the target base cylinder. Typically, the target 5, 50 may have an outer diameter of about 100 mm to about 200 mm, more typically of about 130 mm to about 170 mm, most typically of about 150 mm to about 160 mm. The inner diameter of the target 5, 50 may be in the range of about 80 mm to about 180 mm, more typically of about 110 mm to about 150 mm, most typically of about 130 to about 140 mm. The thickness of the target may be in the range of about 3 mm to about 30 mm, most typically about 20 mm. Typically, the length of the target 5 may be in a range of about 240 mm to about 1540 mm, more typically of about 440 mm to about 1340 mm, most typically about 440 mm to about 540 mm. The outer diameter of the backing tube 4 in the middle part may be in the range of about 80 mm to about 180 mm, more typically of about 110 mm to about 150 mm, most typically of about 130 to about 140 mm. The inner diameter of backing tube 4 may typically be in the range of about 60 mm to 160 mm, more typically about 90 to about 130 mm, most typically about 110 mm to 120 mm. The length of the backing tube 4 may be in a range of about 300 mm to about 1600 mm, more typically of about 500 mm to about 1400 mm, most typically about 500 mm to about 600 mm. Typically, the inner diameter of the target 5, 50 and the outer diameter of the backing tube 4 are chosen such that the spacing between the inner surface of the target 5, 50 and the lateral surface 3 of the backing tube 4 is equal to or less than 0.7 mm, in order to provide a desired heat transfer between the target and the backing tube. In some examples of embodiments disclosed herein, the outer and/or inner diameters of the middle part of the backing tube 4 are substantially constant over the length of the middle part 12. Further, in some examples of embodiments disclosed herein, the outer and/or inner diameters of the target 5, 50 are substantially constant over the length of the target 5, 50.

As an example of a target material used in embodiments disclosed herein, the target 5 may include Silicon, e.g. 5N quality, which may be doped with Boron, e.g. Z-600.

Typically, examples of embodiments disclosed herein are suitable for a substantially horizontal mounting, or, in relation to a horizontal line, even a somewhat inclined mounting of the rotatable target 1, since e.g. the springs 21 and 27 provide for a reliable alignment or centering of the tubular solid target 5.

According to a further embodiment, a method of producing a rotatable target for sputtering installations is provided, including the steps of providing a rotatable target device or a rotatable target base device for sputtering installations according to any example of embodiments or to any embodiment described herein; providing a solid target cylinder; and arranging the solid target cylinder on the lateral surface of the target base cylinder. The method may include, after the step of arranging the solid target cylinder, a step of installing at at least one of the first and the second end regions of the target base cylinder a target fixation means.

Further, the solid target cylinder may be a hollow cylinder. The solid target cylinder may be arranged concentrically on the target base cylinder. Typically, by combining the solid target cylinder and the target base cylinder according to above further embodiment, the rotatable target is formed. The rotatable target may be for substantially horizontally mounting a sputtering target in a sputtering installation.

In one example of a method of embodiments described herein, backing tube 4 shown in Fig. 2b is provided. Then, spring 21 is concentrically positioned on backing tube 4 at the second end region 9 and moved from the second end region 9 to the first end region 7. Thereafter, tubular solid target 5 is concentrically placed on the second end region 9, moved in parallel to the central axis 40, i.e. in the present example a longitudinal axis, of the backing tube 4 and placed in contact to spring 21. Then, spring 27 is concentrically placed on backing tube 4 in contact to target 5. Subsequently, the elements of locking means 23 are mounted at end region 9, by concentrically positioning compression flange 24 with its bore 240 on bolt 26 and in contact to lid 8, the protrusion 39 facing target 5 and spring 27 filling recess 280. Thereafter, the nut 23 is fixed at bolt 26. As a result, tubular solid target 5 is aligned or centered between springs 21 and 27, providing the rotatable target 1 shown in Fig. 1. Target adjusting gaps 28 and 29, which are variable because of springs 21 and 27, allow for thermal expansion of the target material in parallel to the rotational axis of the rotatable target 1. In some embodiments, spring 21 is made of electrically conductive material, such that it provides a defined potential of the target 5.

As mentioned above, the second end region 9 of backing tube 4 may have a maximum outer diameter substantially equal to or less than the outer diameter of the middle part. Therefore, tubular solid target 5, which has an inner diameter substantially equal to or larger than the outer diameter of the middle part of the backing tube, can be placed on the backing tube 4 by concentrically arranging it on the second end region 9 and moving or pushing it on the backing tube 4 in parallel to the rotational axis, i.e. in the present example the longitudinal axis, of the backing tube. Furthermore, this procedure may also be used when restoring the rotatable target 1 for replacing a depleted target 5. For instance, a replacement may be performed by dismounting the target fixation means 13 from the rotatable target 1 as shown in Fig. 1, removing the target 5, concentrically arranging another target 5 on the backing tube 4, and mounting the target fixation means 13 again at the backing tube 4.

Further, the solid target cylinder may be a hollow cylinder. The solid target cylinder may be arranged concentrically on the target base cylinder. The rotatable target may be for substantially horizontally mounting a sputtering target in a sputtering installation. Typically, using the solid target cylinder and the target base cylinder according to embodiments, the rotatable target can be restored. This is possible using the rotatable target base device and the rotatable target, respectively, according to embodiments disclosed herein, since at at least one side of the target base cylinder the target fixation means for holding the target cylinder on the target base cylinder may be removed. For instance, in some embodiments, one of the target fixation means is a removable collar or removable clamping collar. Moreover, in case of a horizontally held rotatable target connected to a target base support, e.g. a bearing and/or a drive, at only one side, at the side without target base support the target fixation means can be removed for exchanging the target cylinder.

In some embodiments, the target fixation means is adapted to provide the target adjusting gap adjacent to the solid target cylinder and/or between the retaining means and the solid target cylinder. According to embodiments, the retaining means may include at least one element chosen from: a flange provided at one of the end regions of the target base cylinder, a compression flange, a flange bearing, a flange fixation member, and an adjusting recess adapted for at least partially containing the target adjusting means, and/or the target fixation means may be adapted to provide the target adjusting gap adjacent to at least one of the elements of the retaining means and/or between two of the elements of the retaining means.

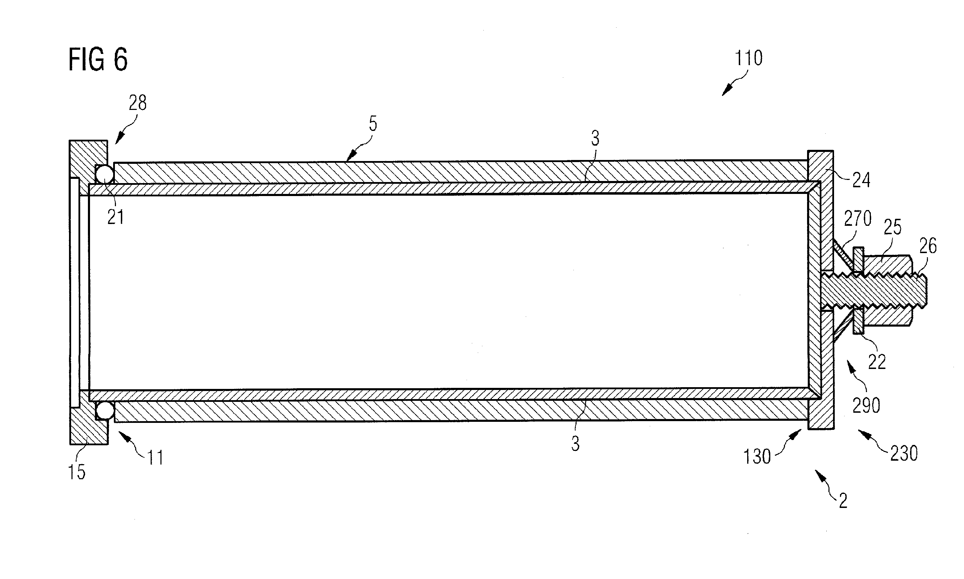

Fig. 6 schematically illustrates as a further embodiment a rotatable target 110. Rotatable target 110 includes the backing tube 4, the rotatable target base device 2 shown in Fig. 2b and a target fixation means 130. The tubular solid target 5 of rotatable target 110 is also shown. For completion of the target fixation means 11, in annular recess 17 of flange 15 the coiled annular spring 21 is provided. Furthermore, the assembled target fixation means 130 includes an annular locking means 230. In the present example, locking means 230 includes bolt 26, the screw nut 25 and the compression flange 24 as well as a disc spring 270. At lid 8 of the backing tube 4, the central bolt 26 is provided. The central bolt 26 has an external thread corresponding to an internal thread of nut 25. As shown in Fig. 6, nut 25 may further include a washer 22. Locking means 230 provides an annular adjusting gap 290 between nut 25, or, if present, washer 22, and the compression flange 24. For assembling target fixation means 130, compression flange 24 is concentrically positioned with the central bore 240 on central bolt 26, in contact to lid 8 of the backing tube 4. Further, disc spring 270 is positioned adjacent to compression flange 24 and nut 23 is fixed over disc spring 270. Thereby, an elastic force of disc spring 270 is established and the target adjusting gap 290 is formed. As a result, tubular solid target 5 is aligned or centered between springs 21 and 270, providing the rotatable target 1 shown in Fig. 6. Target adjusting gaps 28 and 290, which are variable because of springs 21 and 270, allow for thermal expansion of the target material in parallel to the rotational axis of the rotatable target 1. In addition, spring 21 may be made of electrically conductive material, such that a defined potential of the target 5 is provided.

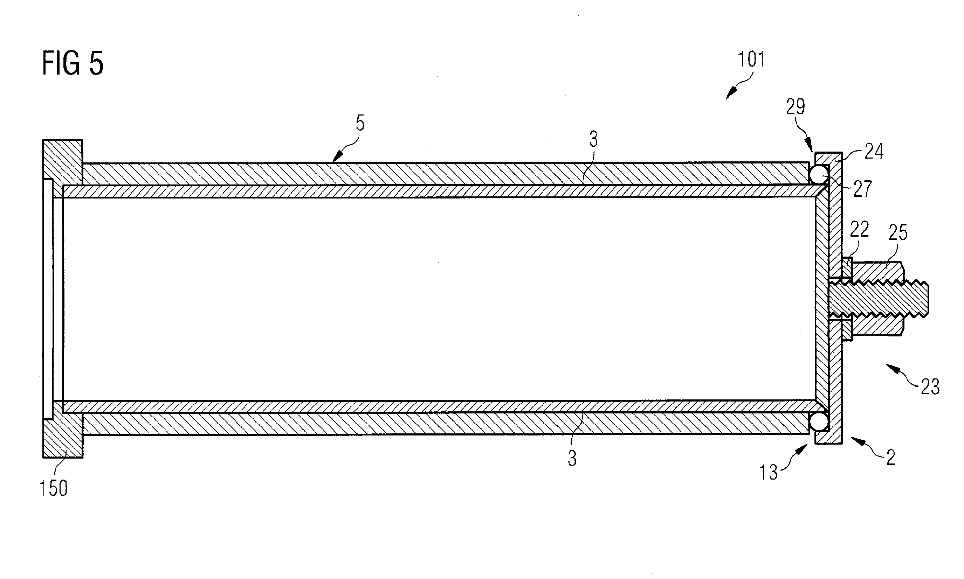

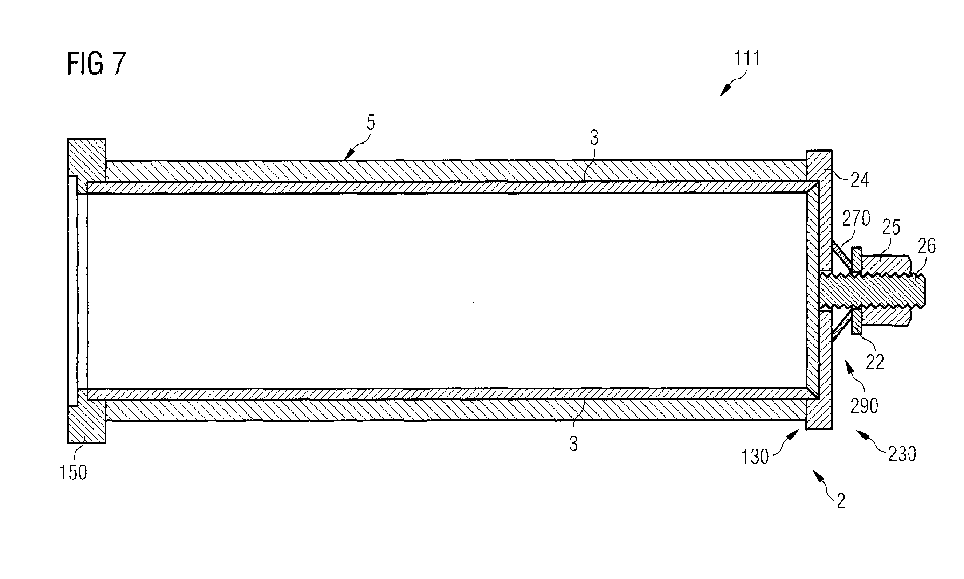

In variations of above embodiments of the rotatable target 1 or rotatable target 110, of the target base devices and of the methods, only one of the target fixation means, and hence only one target adjusting means, may be provided at the backing tube 4 for positioning, e.g. aligning or centering, the tubular solid target thereon. For instance, instead of flange 15 including the recess 17, as a connecting means to a target base support, a flange without recess 17 may be provided. Examples of such embodiments are illustrated in Figs. 5 and 7, showing rotatable targets 101 and 111, respectively, which differ from rotatable targets 1 and 110 shown in Figs. 1 and 6 in that only the target fixation means 13 or 130, respectively, is provided at end region 9. End region 7 is provided with flange 150, which is in direct contact to the adjacent front face 56 of the target 5.

Embodiments disclosed herein allow for providing a cylindrical target, which may be a solid target material tube, on a backing cylinder, e.g. a backing tube, since access from at least one end of the backing cylinder is possible. This is e.g. due to the structure of the backing cylinder of some embodiments, in which at least one end region of the backing cylinder has a maximum outer diameter substantially equal to or less than an outer diameter of the middle part of the backing cylinder. Therefore, a cylindrical or tubular solid target having an inner diameter matching an outer diameter of the middle part of the backing cylinder may be easily placed on the backing cylinder via the end region having a maximum outer diameter substantially equal to or less than an outer diameter of the middle part of the backing cylinder. Furthermore, according to embodiments disclosed herein, the at least one end region may be provided with a removable target fixation means, which may be removed when placing the cylindrical target on the backing cylinder. The target may be designed for use as a bonded or non-bonded target, typically as a non-bonded target. If the target is used as a non-bonded target, as a result of embodiments disclosed herein, expensive bonding of a solid target to a backing cylinder may be avoided, the more so as use of extensive bonding material is not required for fixation of the target on the backing cylinder. In other examples, a solid target may be provided on a backing tube of the sputtering cathode by bonding, which may require bonding material.

Furthermore, since, according to embodiments, the flexible element and/or one or more target fixation means are provided at the backing cylinder, which allow for at least one target adjusting gap between the cylindrical solid target and the target fixation means or between elements of the target retaining means, the thermal expansion coefficient of the backing cylinder material and of the target material may be different. In addition, in examples of embodiments, which include the flexible element and/or the target fixation means, the target may be fixed to the backing cylinder, or even centered or aligned on the backing cylinder in a desired position. Because of the flexible element and/or the target adjusting gap, embodiments disclosed herein allow for a thermal expansion of the solid target cylinder in axial direction, when the target cylinder is disposed on the rotatable target device or rotatable target base device, respectively. Hence, no damage or cracking of the solid target cylinder occurs, even if the material of the solid target cylinder includes Silicon or is formed of Silicon of a high purity.

In one embodiment, a rotatable target device for sputtering installations includes: a rotatable target base adapted for holding a solid target cylinder, the solid target cylinder having an inner axial face, an outer axial face and at least one front face connecting the inner axial face with the outer axial face; wherein the rotatable target base includes a flexible element, a first face adapted to the shape of the inner axial face of the solid target cylinder and a second face adapted to hold the flexible element outside of the solid target cylinder.

In one embodiment, which can be combined with any other embodiment described herein, the flexible element is adapted to be in direct contact with the front face of the solid target cylinder.

In one embodiment, which can be combined with any other embodiment described herein, the flexible element includes a solid element adapted to be in direct contact with the front face of the solid target cylinder.

In another embodiment, which can be combined with any other embodiment described herein, a rotatable target base device for sputtering installations is provided, wherein the target base device is adapted for receiving at least one solid target cylinder, the rotatable target base device including a target base cylinder having an axis, a lateral surface, a middle part, a first end region, and a second end region opposite to the first end region; and at least one target fixation means adapted to provide a target adjusting gap which is variable substantially in parallel to at least one element chosen from the lateral surface and the axis of the target base cylinder.

In one embodiment, which can be combined with any other embodiment described herein, the target fixation means includes at least one element chosen from a retaining means and a target adjusting means, the target adjusting means being adapted to provide the target adjusting gap and/or being adapted to be provided in the target adjusting gap.

In one embodiment, which can be combined with any other embodiment described herein, the target base cylinder is tubular and the target fixation means is adapted to provide the target adjusting gap variable substantially in parallel to the axis.

In one embodiment, which can be combined with any other embodiment described herein, at least one element chosen from the flexible element, the target fixation means and the target adjusting means includes at least one element chosen from: an elastic member, an annular elastic member, a spring, a disc spring, a coiled spring, an annular spring, an annular coiled spring, a spring made from a flat metal stripe, a coiled spring made from a flat metal stripe, an annular spring made from a flat metal stripe, an annular coiled spring made from a flat metal stripe, an electrically conductive material, a metal, and stainless steel.

In one embodiment, which can be combined with any other embodiment described herein, the target fixation means is removable.

In one embodiment, which can be combined with any other embodiment described herein, at least one element chosen from the retaining means and the target adjusting means is removable.

In one embodiment, which can be combined with any other embodiment described herein, at least one of the first and the second end regions has a maximum outer diameter substantially equal to or less than an outer diameter of the middle part.

In one embodiment, which can be combined with any other embodiment described herein, one of the at least one target fixation means is adapted for being provided at the at least one of the first and the second end regions and is removable.

In one embodiment, which can be combined with any other embodiment described herein, the target fixation means is adapted to provide the target adjusting gap adjacent to the solid target cylinder and/or between the retaining means and the solid target cylinder.

In one embodiment, which can be combined with any other embodiment described herein, the retaining means includes at least one element chosen from: a flange provided at one of the end regions of the target base cylinder, a compression flange, a flange bearing, a flange fixation member, and an adjusting recess adapted for at least partially containing the target adjusting means.

In one embodiment, which can be combined with any other embodiment described herein, the target fixation means is adapted to provide the target adjusting gap in at least one position chosen from: adjacent to at least one of the elements of the retaining means and between two of the elements of the retaining means.

In one embodiment, which can be combined with any other embodiment described herein, at least one of the at least one target fixation means includes a connecting means adapted for connecting the target base device to a target base support.

In one embodiment, which can be combined with any other embodiment described herein, the first end region is provided with a connecting means adapted for connecting the target base device to a target base support; and/or wherein the connecting means forms the retaining means of one of the at least one target fixation means.

In one embodiment, which can be combined with any other embodiment described herein, the second end region has a maximum outer diameter substantially equal to or less than an outer diameter of the middle part and is adapted for being provided with one of the at least one target fixation means.

In one embodiment, a rotatable target for sputtering installations includes a rotatable target device for sputtering installations, the rotatable target device including: a rotatable target base adapted for holding a solid target cylinder, the solid target cylinder having an inner axial face, an outer axial face and at least one front face connecting the inner axial face with the outer axial face; wherein the rotatable target base includes a flexible element, a first face adapted to the shape of the inner axial face of the solid target cylinder and a second face adapted to hold the flexible element outside of the solid target cylinder.

In one embodiment, which can be combined with any other embodiment described herein, a rotatable target for sputtering installations is provided, including a rotatable target base device for sputtering installations, wherein the target base device is adapted for receiving at least one solid target cylinder; the rotatable target base device including a target base cylinder having an axis, a lateral surface, a middle part, a first end region, and a second end region opposite to the first end region; and at least one target fixation means adapted to provide a target adjusting gap which is variable substantially in parallel to at least one element chosen from the lateral surface and the axis of the target base cylinder; the rotatable target base device having at least one solid target cylinder arranged on the lateral surface of the target base cylinder, wherein the at least one target fixation means provides a target adjusting gap which is variable substantially in parallel to at least one element chosen from the lateral surface and the axis of the target base cylinder.

One embodiment, which can be combined with any other embodiment described herein, includes at least one element chosen from: the rotatable target base device having at least one of the at least one target fixation means arranged at at least one of the first and the second end regions; at least one of the at least one target fixation means being removable; the target fixation means including at least one element chosen from the retaining means and the target adjusting means, the target adjusting means providing the target adjusting gap or being provided in the target adjusting gap; at least one of the first and the second end regions of the target base cylinder having a maximum outer diameter substantially equal to or less than an outer diameter of the middle part; and the inner diameter of the at least one solid target cylinder being substantially equal to or larger than the outer diameter of the middle part of the target base cylinder.

In one embodiment, which can be combined with any other embodiment described herein, includes at least one element chosen from: the at least one solid target cylinder being located between the first and the second end region; the at least one solid target cylinder having a position adjusted by the at least one target fixation means; the target fixation means providing the target adjusting gap at a position chosen from: adjacent to the solid target cylinder, and between the retaining means and the at least one solid target cylinder; and the target fixation means providing the target adjusting gap at a position chosen from: adjacent to at least one of the elements of the retaining means and between two of the elements of the retaining means.

In one embodiment, which can be combined with any other embodiment described herein, a coating installation includes a rotatable target device for sputtering installations, the rotatable target device including: a rotatable target base adapted for holding a solid target cylinder, the solid target cylinder having an inner axial face, an outer axial face and at least one front face connecting the inner axial face with the outer axial face; wherein the rotatable target base includes a flexible element, a first face adapted to the shape of the inner axial face of the solid target cylinder and a second face adapted to hold the flexible element outside of the solid target cylinder.

In one embodiment, which can be combined with any other embodiment described herein, a coating installation including a rotatable target base device for sputtering installations is provided, wherein the target base device is adapted for receiving at least one solid target cylinder, the rotatable target base device including a target base cylinder having an axis, a lateral surface, a middle part, a first end region, and a second end region opposite to the first end region; and at least one target fixation means adapted to provide a target adjusting gap which is variable substantially in parallel to at least one element chosen from the lateral surface and the axis of the target base cylinder

In one embodiment, which can be combined with any other embodiment described herein, a method of producing a rotatable target for sputtering installations includes: providing a rotatable target device for sputtering installations, the rotatable target device including: a rotatable target base adapted for holding a solid target cylinder, the solid target cylinder having an inner axial face, an outer axial face and at least one front face connecting the inner axial face with the outer axial face; wherein the rotatable target base includes a flexible element, a first face adapted to the shape of the inner axial face of the solid target cylinder and a second face adapted to hold the flexible element outside of the solid target cylinder; providing a solid target cylinder; the method including at least one step chosen from: arranging the solid target cylinder on the lateral surface of the target base cylinder adjacent to the at least one target fixation means; arranging at the first end region of the target base cylinder one of the at least one target fixation means, and arranging at the second end region of the target base cylinder one of the at least one target fixation means.

In one embodiment, which can be combined with any other embodiment described herein, a method of producing a rotatable target for sputtering installations includes: providing a rotatable target base device for sputtering installations, wherein the target base device is adapted for receiving at least one solid target cylinder; the rotatable target base device including a target base cylinder having an axis, a lateral surface, a middle part, a first end region, and a second end region opposite to the first end region; and at least one target fixation means adapted to provide a target adjusting gap which is variable substantially in parallel to at least one element chosen from the lateral surface and the axis of the target base cylinder; providing a solid target cylinder; the method including at least one step chosen from: arranging the solid target cylinder on the lateral surface of the target base cylinder adjacent to the at least one target fixation means; arranging at the first end region of the target base cylinder one of the at least one target fixation means, and arranging at the second end region of the target base cylinder one of the at least one target fixation means.

In some embodiments described herein, the rotatable target base is the target base cylinder according to any embodiment described herein; and/or the first face is the lateral surface according to any embodiment described herein; and/or the second face is included in at least one element chosen from: the target base cylinder and/or the retaining means according to any embodiment described herein, and one of the elements of the retaining means according to any embodiment described herein; and/or the flexible element is at least one element chosen from the target fixation means and the target adjusting means according to any embodiment described herein; and/or the solid element is at least one element chosen from: a part of the retaining means, the compression flange, and the flange bearing, according to any embodiment described herein.

The written description uses examples to disclose the invention, including the best mode, and also to enable any person skilled in the art to make and use the invention. While the invention has been described in terms of various specific embodiments, those skilled in the art will recognize that the invention can be practiced with modifications within the spirit and scope of the claims. Especially, mutually non-exclusive features of the examples of embodiments described above may be combined with each other. The patentable scope of the invention is defined by the claims, and may include other examples that occur to those skilled in the art. Such other examples are intended to be within the scope of the claims.

While the foregoing is directed to embodiments of the invention, other and further embodiments of the invention may be devised without departing from the basic scope thereof, and the scope thereof is determined by the claims that follow.

## Claims

1. A rotatable target device for sputtering installations, comprising:
a rotatable target base (4) adapted for holding a solid target cylinder (5), the solid target cylinder having an inner axial face (54), an outer axial face (55) and at least one front face (56) connecting the inner axial face with the outer axial face;
wherein the rotatable target base comprises a flexible element (23; 230), a first face (3) adapted to the shape of the inner axial face of the solid target cylinder and a second face (250; 81) adapted to hold the flexible element outside of the solid target cylinder.

2. The rotatable target device for sputtering installations according to claim 1,
wherein the flexible element is adapted to be in direct contact with the front face (56) of the solid target cylinder; and/or
wherein the flexible element comprises a solid element adapted to be in direct contact with the front face (56) of the solid target cylinder.

3. A rotatable target base device for sputtering installations, wherein the target base device is adapted for receiving at least one solid target cylinder (5), the rotatable target base device comprising
a target base cylinder (4) having an axis (40), a lateral surface (3), a middle part (12), a first end region (7), and a second end region (9) opposite to the first end region; and
at least one target fixation means (11, 13) adapted to provide a target adjusting gap (28; 29) which is variable substantially in parallel to at least one element chosen from the lateral surface and the axis of the target base cylinder.

4. The rotatable target base device of claim 3, wherein the target fixation means comprises at least one element chosen from a retaining means (15; 23; 230) and a target adjusting means (21; 27; 270), the target adjusting means being adapted to provide the target adjusting gap and/or being adapted to be provided in the target adjusting gap; and/or
wherein the target base cylinder is tubular and the target fixation means is adapted to provide the target adjusting gap variable substantially in parallel to the axis.

5. The rotatable target base device of any of claims 1 to 4, wherein at least one element chosen from the flexible element, the target fixation means and the target adjusting means comprises at least one element chosen from: an elastic member, an annular elastic member, a spring, a disc spring, a coiled spring, an annular spring, an annular coiled spring, a spring made from a flat metal stripe, a coiled spring made from a flat metal stripe, an annular spring made from a flat metal stripe, an annular coiled spring made from a flat metal stripe, an electrically conductive material, a metal, and stainless steel;
and/or
wherein at least one element chosen from the target fixation means, the retaining means and the target adjusting means is removable.

6. The rotatable target base device of any of claims 3 to 5, wherein at least one of the first and the second end regions has a maximum outer diameter substantially equal to or less than an outer diameter of the middle part; and/or
wherein one of the at least one target fixation means (13) is adapted for being provided at the at least one of the first and the second end regions and is removable.

7. The rotatable target base device of any of claims 3 to 6, wherein the target fixation means is adapted to provide the target adjusting gap adjacent to the solid target cylinder and/or between the retaining means and the solid target cylinder; and/or
wherein the retaining means comprises at least one element chosen from:
a flange (15) provided at one of the end regions of the target base cylinder, a compression flange (24), a flange bearing (26), a flange fixation member (22), and an adjusting recess (17; 25) adapted for at least partially containing the target adjusting means; and/or
wherein the target fixation means is adapted to provide the target adjusting gap adjacent to at least one of the elements of the retaining means and/or between two of the elements of the retaining means.

8. The rotatable target base device of any of claims 3 to 7,
wherein at least one of the at least one target fixation means (15) comprises a connecting means (15) adapted for connecting the target base device to a target base support; and/or
wherein the first end region is provided with a connecting means (15) adapted for connecting the target base device to a target base support; and/or
wherein the connecting means forms the retaining means of one of the at least one target fixation means; and/or
wherein the second end region (9) has a maximum outer diameter substantially equal to or less than an outer diameter of the middle part and is adapted for being provided with one of the at least one target fixation means.

9. The rotatable target device of claim 1 or 2,
wherein the rotatable target base is the target base cylinder according to any of claims 3 to 8; and/or
wherein the first face is the lateral surface according to any of claims 3 to 8; and/or
wherein the second face is included in at least one element chosen from:
the target base cylinder according to any of claims 3 to 8, the retaining means according to any of claims 3 to 8, and one of the elements of the retaining means according to claim 7; and/or
wherein the flexible element is at least one element chosen from the target fixation means and the target adjusting means according to any of claims 3 to 8; and/or
wherein the solid element is at least one element chosen from: a part of the retaining means, the compression flange, and the flange bearing, according to any of claims 3 to 8.

10. A rotatable target for sputtering installations, comprising a rotatable target device or a rotatable target base device according to any of claims 3 to 9, the rotatable target base device having at least one solid target cylinder arranged on the lateral surface of the target base cylinder,
wherein the at least one target fixation means (11, 13) provides a target adjusting gap which is variable substantially in parallel to at least one element chosen from the lateral surface and the axis of the target base cylinder.

11. The rotatable target for sputtering installations of claim 10,
wherein the rotatable target base device has at least one of the at least one target fixation means arranged at at least one of the first and the second end regions; and/or
wherein at least one of the at least one target fixation means is removable; and/or
wherein the target fixation means comprises at least one element chosen from the retaining means (15; 23; 230) and the target adjusting means (21; 27), the target adjusting means providing the target adjusting gap and/or being provided in the target adjusting gap, and/or
wherein at least one of the first and the second end regions of the target base cylinder has a maximum outer diameter substantially equal to or less than an outer diameter of the middle part; and/or
wherein the inner diameter of the at least one solid target cylinder is substantially equal to or larger than the outer diameter of the middle part of the target base cylinder.

12. The rotatable target of claim 10 or 11, wherein the at least one solid target cylinder is located between the first and the second end region, and/or has a position adjusted by the at least one target fixation means; and/or
wherein the target fixation means provides the target adjusting gap adjacent to the solid target cylinder and/or between the retaining means and the at least one solid target cylinder; and/or
wherein the target fixation means provides the target adjusting gap adjacent to at least one of the elements of the retaining means and/or between two of the elements of the retaining means.

13. A coating installation comprising a rotatable target device or a rotatable target base device according to any of claims 1 to 9 and/or a rotatable target according to any of claims 10 to 12.

14. A method of producing a rotatable target for sputtering installations, comprising
providing a rotatable target device or a rotatable target base device according to any of claims 1 to 9,
providing a solid target cylinder,
arranging the solid target cylinder on the lateral surface of the target base cylinder adjacent to the at least one target fixation means.

15. The method of claim 14, comprising at least one step chosen from:
arranging at the first end region of the target base cylinder one of the at least one target fixation means, and
arranging at the second end region of the target base cylinder one of the at least one target fixation means.
